# EUROPEAN PATENT APPLICATION

(11) **EP 2 006 906 A2**
(43) Date of publication of application: **24.12.2008**
(21) Application number: 07714653.8
(22) Date of filing: 21.02.2007
(51) Int. Cl.: H01L 23/10, H03H 9/25

(54) **ELECTRONIC COMPONENT AND METHOD FOR MANUFACTURING SAME**

(30) Priority: 07.04.2006 JP 2006106086; 05.01.2007 JP 2007000394
(71) Applicant: Murata Manufacturing Co. Ltd., Nagaokakyo-shi, Kyoto 617-8555 (JP)
(72) Inventor: FUJINO, Hiroyuki, Nagaokakyo-shi, Kyoto 617-8555 (JP); KOSHIDO, Yoshihiro, Nagaokakyo-shi, Kyoto 617-8555 (JP); AIZAWA, Naoko, Nagaokakyo-shi, Kyoto 617-8555 (JP); YAMADA, Hajime, Nagaokakyo-shi, Kyoto 617-8555 (JP); UESAKA, Kenichi, Nagaokakyo-shi, Kyoto 617-8555 (JP)
(74) Representative: Schoppe, Fritz
(86) International application number: PCT/JP2007/053153
(87) International publication number: WO 2007/129496

(57) **Abstract**

There are provided an electronic component in which two substrates are bonded to each other with a large bonding force and a method for manufacturing electronic components in which two substrates can be bonded to each other with a large bonding force and in which the substrates are not likely to be bent and broken.

A plurality of first connection portions 30 is formed on a first substrate 22, and in addition, a plurality of IDT electrodes 26 and a plurality of second connection portions 32 are formed on a second substrate 24. The first connection portions 30 are engaged in concave parts of the second connection portions 32, so that temporary bonding is performed. Between adjacent first connection portions 30, only the first substrate is cut off. By heat application, laser irradiation, pressure application, ultrasonic application, or the like, the first connection portions 30 and the second connection portions 32 are finally bonded to each other. The second substrate 24 is cut off along the cut portions of the first substrate 22, so that a plurality of electronic components 20 is formed.

## Description

### Technical Field

The present invention relates to an electronic component and a method for manufacturing the same, and more particularly relates to an electronic component having, for example, a chip shape provided between two substrates and to a method for manufacturing the same.

### Background Art

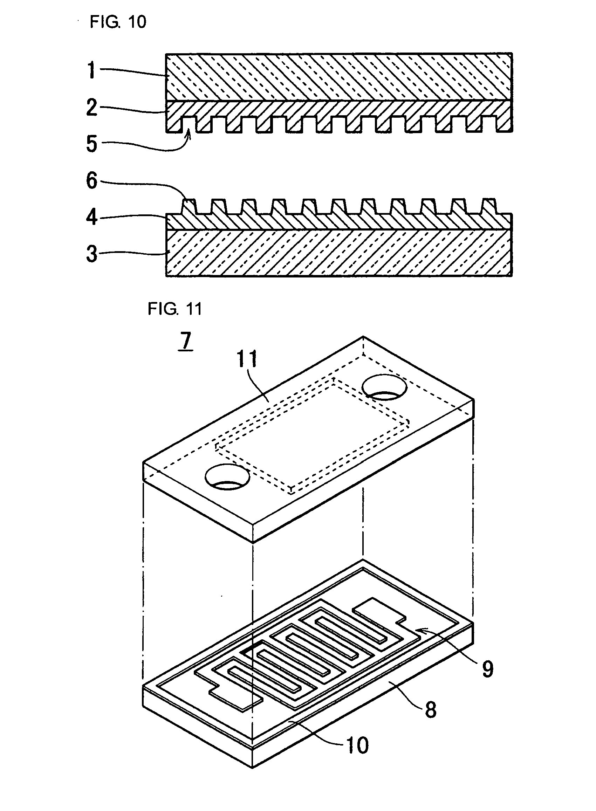

Fig. 10 is a schematic view showing a bonding method for bonding two substrates to be used for a conventional electronic component. A first Al film 2 is formed on a first Pyrex (registered trade name) glass substrate 1. In addition, a second Al film 4 is formed on a second Pyrex (registered trade name) glass substrate 3. Non-tapered concave grooves 5 each having a round shape when viewed in plan are formed in the first Al film 2, and tapered convex teeth 6 each having a round shape when viewed in plan, the top diameter of each of the teeth being smaller than the bottom diameter, are formed from the second Al film 4. When the concave grooves 5 and the convex teeth 6 are engaged with each other, and a compression load is applied thereto at room temperature, due to friction between the Al films 3 and 4, the first substrate 1 and the second substrate 2 are bonded to each other (see Patent Document 1).

In addition, as shown in Fig. 11, there is provided a surface acoustic wave device in which a substrate provided with a surface acoustic wave element formed thereon and a cover substrate are bonded to each other. This surface acoustic wave device 7 includes a piezoelectric substrate 8, and when an interdigital transducer electrode (IDT electrode) 9 is formed on the piezoelectric substrate 8, a piezoelectric element is formed. In addition, an anode bond portion 10 is formed along the edge of the piezoelectric substrate 8 so as to surround the IDT electrode 9. Furthermore, a cover substrate 11 formed of soda glass or the like is provided on the piezoelectric substrate 8 so as to cover the IDT electrode 9. Subsequently, after the cover substrate 11 is placed on the anode bond portion 10, a voltage of 500 V is applied across the anode bond portion 10 and the cover substrate 11, and in addition, the overall structure is also heated to 350°C to perform anode bonding, so that the piezoelectric substrate 8 and the cover substrate 11 are boned to each other. In practical manufacturing, after a plurality of IDT electrodes 9 and a plurality of anode bond portions 10 are formed on a large piezoelectric substrate, and a large cover substrate is placed thereon, anode bonding is performed, followed by cutting to form a plurality of surface acoustic wave devices 7 (see Patent Document 2).
Patent Document 1: Japanese Unexamined Patent Application Publication No. 5-57796
Patent Document 2: Japanese Unexamined Patent Application Publication No. 8-213874

### Disclosure of Invention

### Problems to be Solved by the Invention

However, in the bond structure as disclosed in the Patent Document 1, since the two substrates are bonded to each other by friction between the Al films caused by the compression at room temperature, the bonding force is disadvantageously small. Hence, when chip devices are formed such that after elements are formed on a large substrate, two substrates are bonded to each other and are then cut off, duet to impact generated when the chip devices are formed by cutting, the bond portion may be separated from each other in some cases. In addition, when elements are each sealed with the bond portion, due to the separation of the bond portion, cutting water used in the cutting step performed for forming the chip devices may enter their element portions in some cases. In addition, in the case of the surface acoustic wave device disclosed in the Patent Document 2, since the bonding is performed between the anode bond portion and the primary surface of the cover substrate, the bonding force between the two substrates is disadvantageously small against a force which may cause positional displacement in parallel between the two substrates. In addition, when the anode bonding is performed, since the overall substrates must be heated to 300°C or more, if the coefficients of linear expansion of the two substrates are different from each other, a residual stress is inevitably generated when the bonding temperature is decreased to room temperature. Hence, for example, bending or breakage of the substrates thus bonded may occur.

Accordingly, a primary object of the present invention is to provide an electronic component in which two substrates are bonded to each other with a large bonding force.

In addition, another object of the present invention is to provide a method for manufacturing electronic components in which two substrates can be bonded to each other with a large bonding force and in which the substrates are not likely to be bent and broken.

### Means for Solving the Problems

The present invention provides an electronic component comprising: a first substrate and a second substrate; a first connection portion formed on one primary surface of the first substrate; a second connection portion formed on one primary surface of the second substrate; a bond portion formed at a boundary at which the first connection portion and the second connection portion are in contact with each other; and an element formed on at least one of the first substrate and the second substrate, and the bond portion is formed at a contact portion between a first metal including at least one selected from Ga, In, and Sn and a second metal including at least one selected from Ni, Au, and Cu.

Since the bond portion between the first connection portion and the second connection portion is formed at the contact portion between the first metal and the second metal, a large bonding force can be obtained.

In the electronic component as described above, the bond portion may include an alloy of the first metal and the second metal.

In addition, the bond portion may include a close-contact surface at which the first metal and the second metal are in close contact with each other.

As described above, in more particular, since the bond portion between the first connection portion and the second connection portion is formed of an alloy of the first metal and the second metal or is formed of the close-contact surface between the first metal and the second metal, a large bonding force can be obtained.

In addition, the first connection portion and the second connection portion may be formed by laminating a plurality of materials selected from the first metal and the second metal.

When the bond portion between the first connection portion and the second connection portion has the structure as described above, the first connection portion and the second connection portion may have a laminate structure including a plurality of materials selected from the first metal and the second metal. Accordingly, even if the first metal and the second metal are laminated to each other, when the bond portion between the first connection portion and the second connection portion has the relationship as described above, a large bonding force can be obtained.

In addition, the first connection portion is a convex portion projecting from one primary surface of the first substrate, the second connection portion is a concave part formed in a projecting portion which is formed so as to project from one primary surface of the second substrate, and the first connection portion and the second connection portion are engaged with each other, so that the bond portion can be formed.

Furthermore, the first connection portion may be a convex portion projecting from one primary surface of the first substrate, the second connection portion may be a convex portion projecting from one primary surface of the second substrate, and a side surface of the first connection portion and a side surface of the second connection portion may be in contact with each other so as to form the bond portion at the boundary therebetween.

In addition, the first connection portion may be a convex portion projecting from one primary surface of the first substrate, the second connection portion may be a concave portion formed in one primary surface of the second substrate, and the first connection portion and the second connection portion may be engaged with each other so as to form the bond portion.

As the shape of the first connection portion and that of the second connection portion, various shapes may be used; however, when the shapes thereof are formed so that the first connection portion and the second connection portion catch each other when a force is generated which may cause positional displacement in parallel between the first connection portion and the second connection portion, the bond portion is not likely to be disengaged. That is, a bond having resistance against a shear force can be formed.

In particular, when the second connection portion having a concave shape is formed in the second substrate and is engaged with the first connection portion, the distance between the first substrate and the second substrate can be decreased, and hence the height of the electronic component can be reduced.

In addition, the bond portion may be formed so as to surround an element.

Since the bond portion is formed so as to surround the element, the element formed at the position between the two substrates is sealed with the bond portion, so that the element can be isolated from the outside.

Furthermore, the element may be formed in a dip-shaped cavity portion formed in the first substrate or the second substrate.

Since the element is formed in the cavity portion formed in the substrate, the distance between the two substrates can be further decreased, and the reduction in height can be achieved.

In addition, the element may be formed on a membrane portion formed by decreasing the thickness of the first substrate or the second substrate.

Since the element is formed on the membrane portion formed from the substrate, an oscillator or a pyroelectric infrared sensor may be formed using vibration or a low heat capacity of the membrane portion.

In addition, the present invention provides a method for manufacturing electronic components, comprising the steps of: preparing a first substrate and a second substrate, at least one of which is provided with elements formed on one primary surface thereof; forming first connection portions on one primary surface of the first substrate: forming second connection portions on one primary surface of the second substrate at positions corresponding to the first connection portions when the first substrate and the second substrate are overlapped with each other; bringing the first connection portions and the second connection portions into contact with each other to perform preliminary bonding therebetween; cutting the first substrate or the second substrate into chip shapes having a predetermined size; performing final bonding between the first connection portions and the second connection portions; and cutting the other one of the first substrate and the second substrate into chip shapes having a predetermined size.

Since the first connection portions of the first substrate and the second connection portions of the second substrate are temporarily bonded to each other, followed by the final bonding, a large bonding force can be obtained. In this case, since only one substrate is cut into chip shapes after the temporary bonding, the final bonding can be performed while a plurality of elements are provided in series on one substrate, and in addition, a stress between the first substrate and the second substrate is suppressed within the range of the size of the cut substrate. Hence, bending and/or breakage is not likely to be generated in the substrate. After the final bonding, when the other substrate is cut into chip shapes, a plurality of chip-shaped electronic components can be formed.

In addition, the present invention provides a method for manufacturing electronic components, comprising the steps of: preparing chip-shaped first substrates which are provided with elements formed on primary surfaces thereof and a plate-shaped second substrate; forming first connection portions on primary surfaces of the first substrates: forming second connection portions on one primary surface of the second substrate at positions corresponding to the first connection portions when the first substrates and the second substrate are overlapped with each other; bringing the first connection portions and the second connection portions into contact with each other to perform preliminary bonding therebetween; performing final bonding between the first connection portions and the second connection portions; and cutting the second substrate into chip shapes.

When the first substrates have chip shapes, by performing temporary bonding between the first substrates and the plate-shaped second substrate, the first substrates can be temporarily bonded to the second substrate and further can be finally bonded thereto. Hence, many first substrates can be simultaneously bonded to the second substrate, and compared to the case in which chip-shaped substrates are bonded to each other, efficient bonding can be performed.

In these methods for manufacturing electronic components, contact portions between the first connection portions and the second connection portions may be each formed by bringing a first metal including at least one selected from Ga, In, and Sn into contact with a second metal.

Since temporary bonding and final bonding are performed by bringing the first metal into contact with the second metal, a large bonding force can be obtained.

In addition, the second metal may include at least one selected from Au, Cu, and Ni.

In addition, the first connection portions and the second connection portions may be each formed by laminating a plurality of materials selected from the first metal and the second metal.

When the bond portions between the first connection portions and the second connection portions each have the structure as described above, the first connection portions and the second connection portions may each include a plurality of materials laminated to each other, which are selected from the first metal and the second metal. Hence, even if the first metal and the second metal are laminated to each other, when the bond portions between the first connection portions and the second connection portions each have the relationship as described above, a large bonding force can be obtained.

Furthermore, the first connection portions each may be formed as a convex portion projecting from one primary surface of the first substrate, and the second connection portions each may be formed as a concave portion formed in one primary surface of the second substrate.

When the second connection portions each having a concave shape are formed in the second substrate, and the first connection portions each formed to have a convex shape are engaged with the second connection portions, the distance between the first substrate and the second substrate can be decreased.

In addition, the final bonding between the first connection portions and the second connection portions may be performed by heat application, pressure application, ultrasonic application, laser irradiation, or combination therebetween on the first connection portions and the second connection portions.

When the final bonding is performed by heat application or laser irradiation, as the bond portions between the first connection portions and the second connection portions, an alloy of the first metal and the second metal is formed. In addition, when the final bonding is performed by pressure application or ultrasonic application, clean surfaces are formed at the contact portions between the first connection portions and the second connection portions, and precise close-contact surfaces can be formed.

Furthermore, the first connection portions and the second connection portions may be formed so as to surround the elements.

When the first connection portions and the second connection portions are formed so as to surround the elements, the first substrate and the second substrate can be bonded to each other so as to seal the elements.

In addition, as the first substrate and the second substrate, substrates having a difference in coefficient of linear expansion of 12 ppm/°C or less therebetween, such as a glass substrate having a coefficient of linear expansion of 3.3 ppm/°C and a ceramic substrate having a coefficient of linear expansion of 15.3 ppm/°C, are preferably used. When the two substrates as described above are used, a stress generated therebetween caused by the change in temperature is small.

### Advantages

According to the present invention, the electronic component can be obtained in which the first substrate and the second substrate are bonded to each other with a large bonding force at the bond portion between the first connection portion and the second connection portion. Hence, the two substrates of the electronic component are not likely to be disengaged from each other, and an electronic component which is not likely to be broken can be formed. Furthermore, since the element is sealed with the bond portion, an electronic component having an element isolated from the outside environment can be obtained, and intrusion of moisture and dust into the element portion can be prevented.

In addition, according to the method for manufacturing electronic components of the present invention, the electronic components each having the first substrate and the second substrate bonded to each other with a large bonding force can be formed. In addition, in the process for manufacturing electronic components, bending and breakage of the substrates are not likely to occur, and hence superior productivity can be achieved.

The objects described above, other objects, features, and advantages of the present invention will be more apparent from the following description of the best modes for carrying out the invention performed with reference to the accompanying drawings.

### Brief Description of Drawings

Fig. 1 is an exploded perspective view showing one example of an electronic component of the present invention.
Fig. 2 is a schematic view showing the structure of a connection portion between a connection electrode and a lead portion of an IDT electrode of the electronic component shown in Fig. 1.
Figs. 3(A) to 3(E) are schematic views showing a process for manufacturing the electronic component shown in Fig. 1.
Fig. 4 is a schematic view showing one example of the structure of a first connection portion and a second connection portion of the electronic component shown in Fig. 1.
Figs. 5(A) to 5(E) are schematic views showing another example of the process for manufacturing the electronic component of the present invention.
Fig. 6 is a schematic view showing another example of the electronic component of the present invention.
Fig. 7 is a schematic view showing still another example of the electronic component of the present invention.
Figs. 8(A) to 8(C) are schematic views showing another example of the process for manufacturing the electronic component of the present invention.
Figs. 9(A) to 9(N) are schematic views each showing combination between a first connection portion and a second connection portion of the electronic component of the present invention.
Fig. 10 is a schematic view showing one example of a method for bonding two substrates of a conventional electronic component.
Fig. 11 is an exploded perspective view showing one example of a conventional electronic component.

### Reference Numerals

- 20: electronic component
- 22: first substrate
- 24: second substrate
- 26: IDT electrode
- 28: connection electrode
- 30: first connection portion
- 32: second connection portion
- 34: bond portion
- 40: cavity portion
- 42: element portion

### Best Modes for Carrying Out the Invention

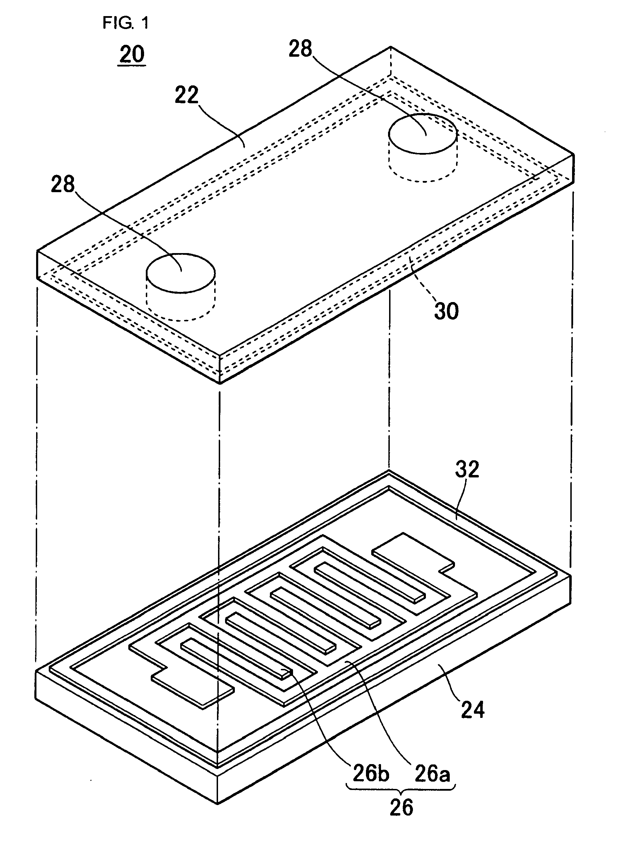

Fig. 1 is an exploded perspective view showing one example of an electronic component of the present invention. In this embodiment, as an electronic component 20, an electronic component having a surface acoustic wave element will be described; however, an electronic component having another element may also be used. The electronic component 20 includes a first substrate 22 and a second substrate 24. For the first substrate 22 used as a cover member, for example, Si is used, and as the second substrate 24 used as a substrate for a surface acoustic wave element, for example, a piezoelectric substrate, such as LiTaO₃, is used. In addition, as materials for the first substrate 22 and the second substrate 24, in accordance with an element to be formed and application of the substrate, besides the materials mentioned above, for example, LiNbO₃, alumina, SiC, sapphire, quartz, Pb(Zr,Ti)O₃, PbTiO₃, BaTiO₃, and SrTiO₃ may also be used.

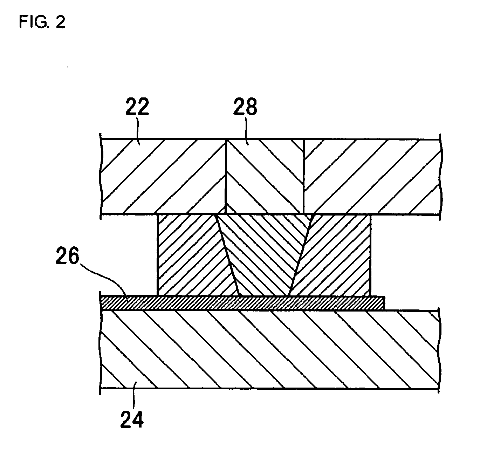

The first substrate 22 and the second substrate 24 are overlapped with and bonded to each other, so that the chip electronic component 20 is formed. In this embodiment, on one primary surface of the second substrate 24, an interdigital transducer (IDT) electrode 26 is formed. The IDT electrode 26 is formed of two comb-shaped electrodes 26a and 26b which are disposed so as to interdigitate with each other. In addition, the number of IDT electrodes 26 and the arrangement thereof, and the dimensions of the comb-shaped electrodes 26a and 26b and the space therebetween are to be determined in accordance with required properties of the surface acoustic wave element. Since the IDT electrode 26 is formed on the second substrate 24 made of a piezoelectric substrate, a surface acoustic wave element is formed. In addition, as shown in Fig. 2, at positions corresponding to lead portions of the IDT electrode 26, connection electrodes 28 are formed in the first substrate 22. The connection electrodes 28 are formed to penetrate the first substrate 22 and are connected to the lead portions of the IDT electrode 26.

Furthermore, a circular first connection portion 30 is formed on one primary surface of the first substrate 22 so as to surround an IDT electrode 26 forming portion, and a circular second connection portion 32 is formed on one primary surface of the second substrate 24. The first connection portion 30 and the second connection portion 32 are formed at positions facing each other when the first substrate 22 and the second substrate 24 are overlapped with each other. When the first connection portion 30 and the second connection portion 32 are bonded to each other, the first substrate 22 and the second substrate 24, which are overlapped with each other, are fixed together. In this case, the lead portions of the IDT electrode 26 and the connection electrodes 28 are also bonded to each other in a manner similar to that for the bond between the first connection portion 30 and the second connection portion 32, so that a mechanical and electrical bond is obtained.

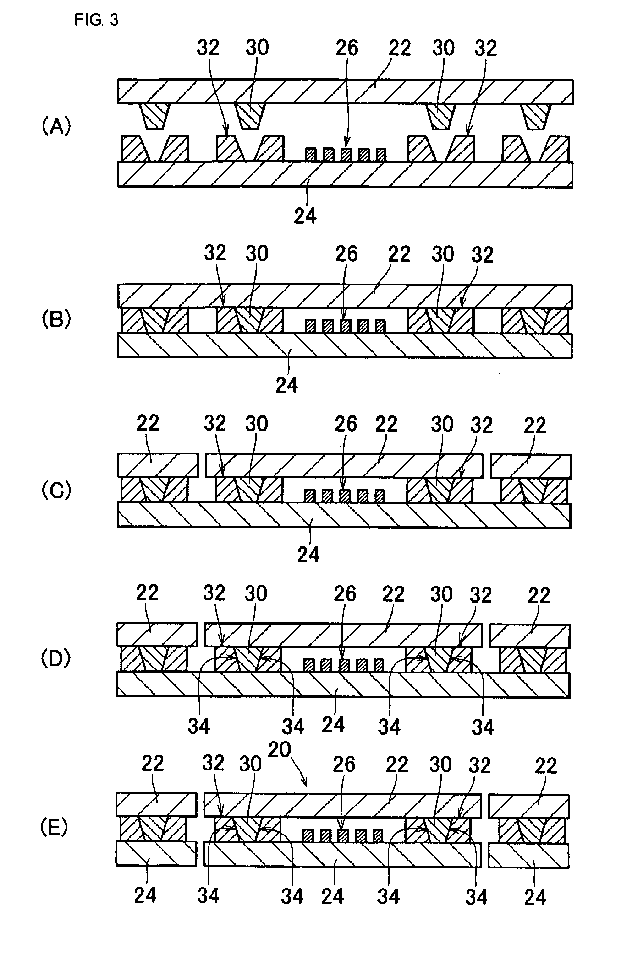

In order to manufacture the electronic components 20, on one primary surface of a large second substrate 24, a plurality of IDT electrodes 26 is formed. Subsequently, a plurality of circular second connection portions 32 is formed so as to surround the respective IDT electrodes 26. The second connection portion 32 is formed, as shown in Fig. 3(A), as a protruding portion protruding from one primary surface of the second substrate 24, and a concave part having a tapered cross-sectional shape, the opening of which being decreased from a front end side toward the second substrate 22, is formed in the protruding portion.

In addition, corresponding to the second substrate 24, a large first substrate 22 is prepared, and a plurality of circular first connection portions 30 is formed at positions corresponding to the second connection portions 32 when the first substrate 22 is overlapped with the second substrate 24. The first connection portion 30 is formed as a convex portion having a tapered cross-sectional shape, the width of which being increased from a front end side toward the first substrate 22. Hence, on one primary surface of the first substrate 22, the convex portions are each formed to have a circular shape, and on one primary surface of the second substrate 24, the protruding portions each having the concave part are formed to have a circular shape.

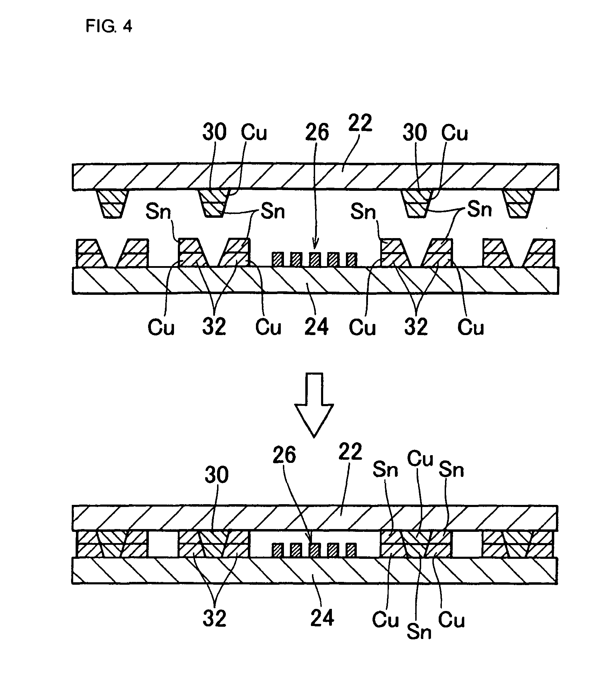

Next, as shown in Fig. 3(B), the first substrate 22 is pressed onto the second substrate 24 so that the first connection portions 30 are engaged in the concave parts of the second connection portions 32. In this case, the first connection portion 30 and the second connection portion 32 are formed so that a first metal including at least one selected from Ga, In, and Sn and a second metal are brought into contact with each other at a position at which the first connection portion 30 and the second connection portion 32 are in contact with each other. In this embodiment, as the second metal, at least one selected from Au, Cu, and Ni is used. For example, the first connection portion 30 may be formed of Sn, and the second connection portion 32 may be formed of Cu. In addition, as shown in Fig. 4, the first connection portion 30 may be formed by laminating Cu and Sn in that order from the first substrate 22 side, and the second connection portion 32 may be formed by laminating Cu and Sn in that order from the second substrate 24 side. In the case of the laminate structures as described above, when the first connection portion 30 is engaged in the concave part of the second connection portion 32, Cu and Sn are to be brought into contact with each other.

As shown in Fig. 3(B), when the first substrate 22 is pressed onto the second substrate 24, the first connection portions 30 are engaged in the concave parts of the second connection portions 32, so that temporary bonding is performed. In the state described above, as shown in Fig. 3(C), between adjacent first connection portions 30, the first substrate 22 is cut off. The cutting of the first substrate 22 may be performed by a method, such as blade dicing, laser dicing, scribing, or cleavage. In this step, the second substrate 24 is not cut off.

Next, as shown in Fig. 3(D), for example, when the overall structure is heated, at contact portions between the first connection portions 30 and the second connection portions 32, bond portions 34 composed of an alloy of the first metal and the second metal are formed. Since the bond portions 34 are formed, final bonding between the first connection portions 30 and the second connection portions 32 is performed. Furthermore, as shown in Fig. 3(E), between adjacent second connection portions 32, the second substrate 24 is cut off, so that the electronic components 20 are formed. The cutting of the second substrate 24 may also be performed by a method, such as blade dicing, laser dicing, scribing, or cleavage.

In addition, although not being shown in Fig. 3, connection between the IDT electrode 26 and the connection electrodes 28 is performed by the method shown in Fig. 3. That is, the second connection portion 32 is formed at each lead portion of the IDT electrode 26, and the first connection portion 30 is formed at the connection electrode 28. In this case, the second connection portion 32 is formed as a protruding portion having a round shape when viewed in plan, and a tapered concave part is formed in the protruding portion, the opening of which being decreased toward the second substrate 24. In addition, as the first connection portion 30, a tapered convex portion which has a round shape when viewed in plan, the diameter of which being increased from a front end side toward the first substrate 22, is formed at the connection electrode 28. In addition, after the first connection portion 30 and the second connection portion 32 are temporarily bonded to each other, final bonding is performed, so that the IDT electrode 26 and the connection electrodes 28 are connected to each other.

In this manufacturing method, after the first connection portions 30 and the second connection portions 32 are temporarily bonded to each other, only the first substrate 22 is cut off. Hence, when the first connection portions 30 and the second connection portions 32 are finally bonded to each other, even if the overall structure is heated, the difference in coefficient of linear expansion between the first substrate 22 and the second substrate 24 influences only on the range of the size of the cut-off first substrate 22; hence, a stress applied to the first substrate 22 and the second substrate 24 can be reduced. Accordingly, in a process for manufacturing the electronic components 20, the first substrate 22 and the second substrate 24 are not likely to be bent and broken. Hence, when the second substrate 24 is cut off after the first connection portions 30 and the second connection portions 32 are finally bonded to each other, the electronic components 20 can be efficiently formed, and superior productivity can be achieved. For example, as described above, even in the case in which the first substrate 22 is formed of Si having a low coefficient of linear expansion, and the second substrate 24 is formed of LiTaO₃ having a high coefficient of linear expansion, these substrates are not likely to be bent and broken.

As the first substrate 22 and the second substrate 24, for example, when two substrates having a difference in coefficient of linear expansion of 12 ppm/°C or less, such as a glass substrate having a coefficient of linear expansion of 3.3 ppm/°C and a ceramic substrate having a coefficient of linear expansion of 15.3 ppm, are used, a stress between the substrates caused by the change in temperature is small, and by using the method as described above, the substrates can be more reliably prevented from being bent and broken.

In addition, since the final bonding is performed following the temporary bonding between the first connection portions 30 and the second connection portions 32, a bonding force can be increased by each bond portion 34. Hence, the IDT electrode 26 forming portion can be reliably sealed, and intrusion of moisture, dust, and the like can be prevented, so that degradation in properties of the electronic component 20 can be prevented. In addition, also in the manufacturing process, intrusion of cutting water or the like used during cutting can be reliably prevented, and generation of defectives caused thereby can be prevented. In addition, the bonding between the IDT electrode 26 and the connection electrodes 28 is reliably performed, and hence an electrical connection state can be ensured.

As the method for performing final bonding between the first connection portions 30 and the second connection portions 32, besides the method for heating the overall structure, when one of the substrates is formed of a glass or the like, heating may be performed by irradiating laser to the contact portions between the first connection portions 30 and the second connection portions 32. By the heating using laser irradiation as described above, laser irradiated portions are only heated, and the other parts of the substrates are not heated; hence, a stress applied to the substrates can be further reduced. In addition, by further applying pressure or ultrasonic waves to the temporarily-bonded contact portions between the first connection portions 30 and the second connection portions 32, clean surfaces may be exposed at the contact portions between the first connection portions 30 and the second connection portions 32 and may be closely brought into contact with each other. As described above, when the surfaces of the first connection portions 30 and the surfaces of the second connection portions 32 are cleaned to form close-contact surfaces, and this close-contact surfaces are used as the bond portions 34, a large bonding force can be obtained. Furthermore, by using at least two methods, such as heat application, laser irradiation, pressure application, and ultrasonic application, in combination, the final bonding between the first connection portions 30 and the second connection portions 32 may be performed.

In addition, in Fig. 3(C), after the first connection portions 30 and the second connection portions 32 are temporarily bonded to each other, only the first substrate 22 is cut off; however, instead of cutting off the first substrate 22, only the second substrate 24 may be cut off. In this case, in the step shown in Fig. 3(E), the first substrate 22 is cut off. As described above, regardless whether the first substrate 22 or the second substrate 24 is first cut off, the substrates can be prevented from being bent or broken caused by the difference in coefficient of linear expansion.

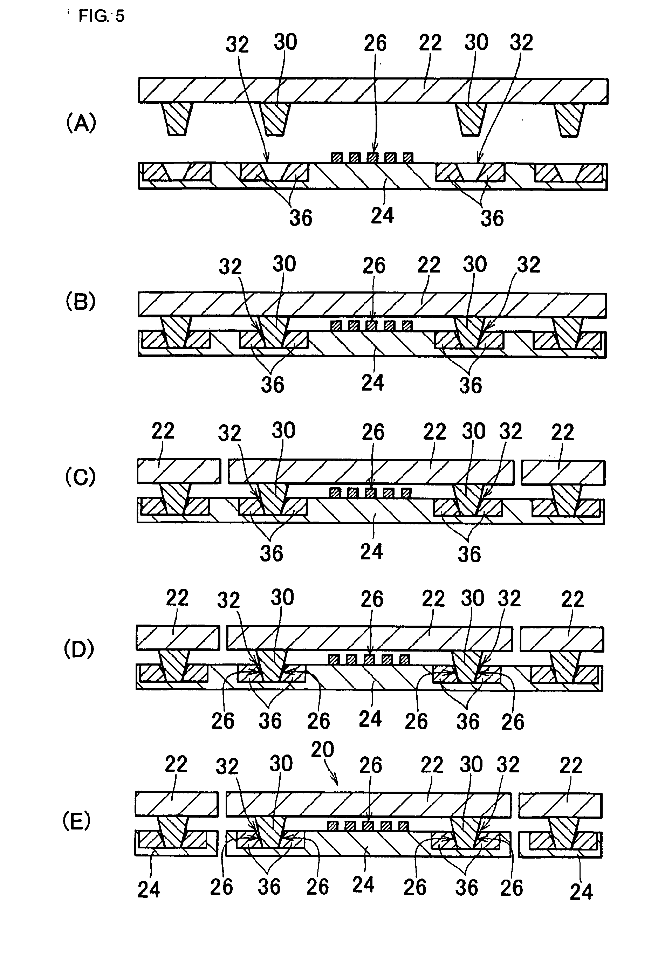

As the second connection portion 32 formed on the second substrate 24, a concave portion may be formed in one primary surface of the second substrate 24 as shown in Fig. 5(A). In the second connection portion 32 as described above, for example, the concave portion is formed in a buried portion 36, which is formed of the first metal or the second metal, buried in the second substrate 24, so that the second connection portion 32 is formed. In this case, for example, holes each having a bottom are formed in the second substrate 24 by a method, such as RIE, milling, or sand blasting, and the buried portions 36 are buried in the holes, so that the second connection portions 32 can be formed. The first connection portion 30 formed on the first substrate 22 and the buried portion 26 forming the second connection portion 32 are formed such that, when the first connection portion 30 and the second connection portion 32 are engaged with each other, the first metal and the second metal are brought into contact with each other. Accordingly, the first connection portion 30 and the second connection portion 32 may be formed of the first metal and the second metal, respectively, or as in the case of the combination between the first connection portion 30 and the second connection portion 32 shown in Fig. 4, laminate structures may be each formed using at least two types of metals selected from the first metal and the second metal.

Also in the case in which the second connection portions 32 as described above are formed, as shown in Fig. 5(B), the first substrate 22 and the second substrate 24 are overlapped with each other, so that the first connection portions 30 and the second connection portions 32 are temporarily boned to each other. In addition, only the first substrate 22 is cut off as shown in Fig. 5(C), the first connection portions 30 and the second connection portions 32 are then finally bonded to each other as shown in Fig. 5(D), and the second substrate 24 is cut off as shown in Fig. 5(E), so that the electronic components 20 are formed. As described above, when the concave portions are formed in one primary surface of the second substrate 24 as the second connection portions 32, compared to the case in which the concave parts are formed in the protruding portions formed on one primary surface of the second substrate 24, the distance between the first substrate 22 and the second substrate 24 can be decreased. Hence, the height of the electronic component 20 finally obtained as a product can be reduced.

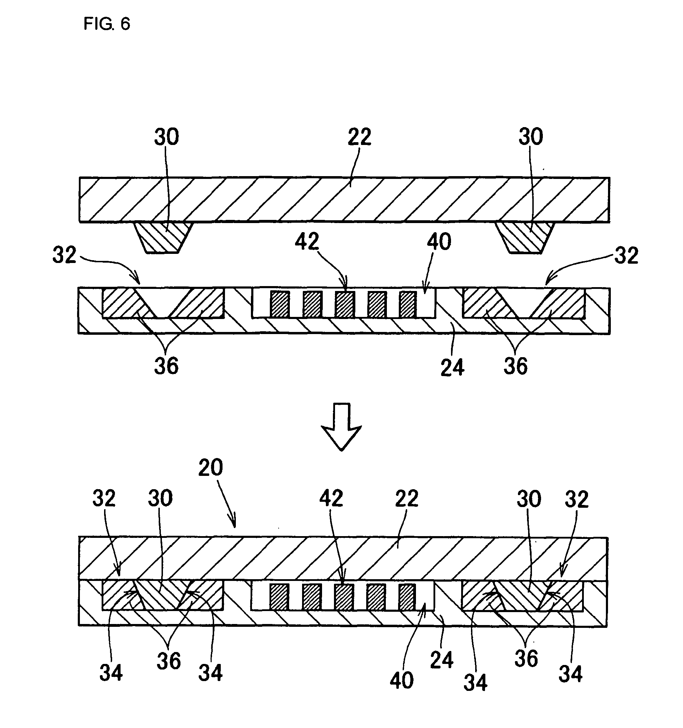

In addition, as shown in Fig. 6, inside the second connection portion 32, a dip is formed in the second substrate 24 as a cavity portion 40, and in this cavity portion 40, an element portion 42 may be formed. When the cavity portion 40 is formed as described above, the first connection portion 30 and the second connection portion 32 can be formed so that the first substrate 22 and the second substrate 24 are brought into contact with each other. By forming the structure as described above, the height of the electronic component 20 can be further reduced.

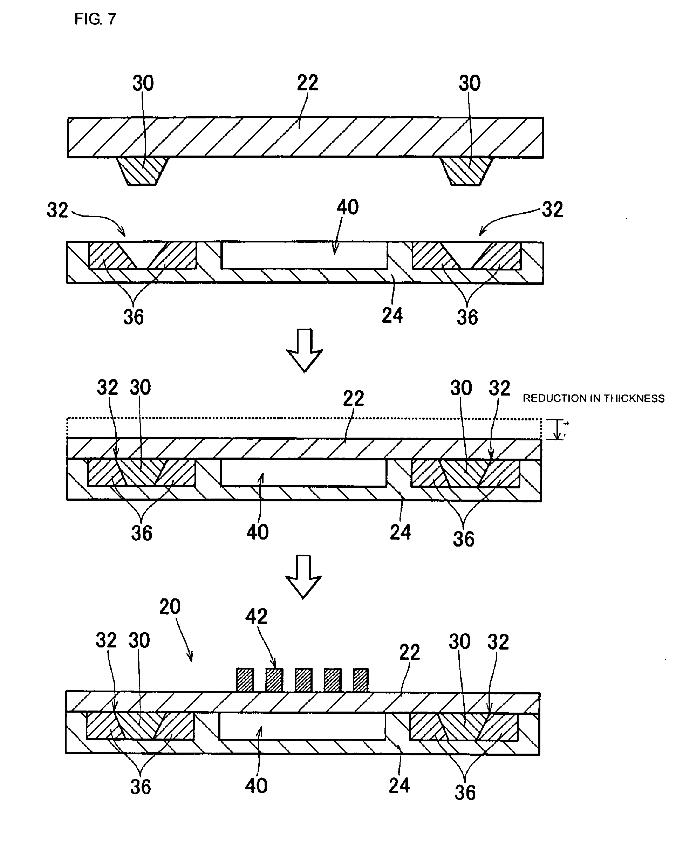

Furthermore, as shown in Fig. 7, after the thickness of the first substrate 22 is decreased, and in addition, the cavity portion 40 is formed in the second substrate 24, the element portion 42 may be formed on the first substrate 22 at a position corresponding to the cavity portion 40. When a membrane structure is formed as described above in which the element portion 42 is formed on the first substrate 22 having a decreased thickness, the element portion 42 can function as an element portion using vibration or a low heat capacitance. As the element portion 42 described above, for example, an oscillator in which the first substrate 22 is formed of a piezoelectric material and electrodes are formed on two surfaces thereof, or an infrared sensor in which the first substrate 22 is formed of a pyroelectric material and electrodes are formed on the surface thereof may be mentioned.

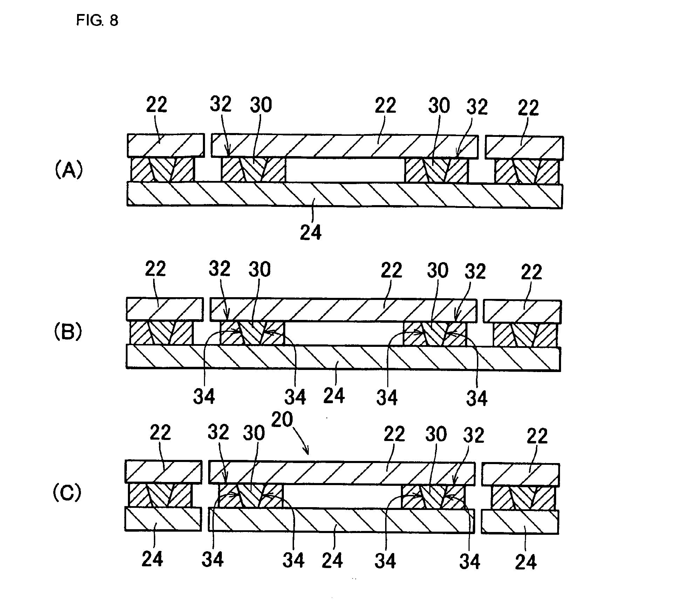

In addition, as shown in Fig. 8, as the first substrate 22, chip-shaped substrates smaller than the second substrate 24 may also be used. As the example as described above, the case may be mentioned in which as the second substrate 24, a wafer provided with a plurality of MEMS elements is used, and as the first substrates 22, IC chips or the like to be bonded to the second substrate 24 are used so as to cover the MEMS elements formed thereon. In the example shown in Fig. 8, a plurality of the MEMS elements is formed on the second substrate 24. On one primary surface of the second substrate 24, a plurality of the second connection portions 32 is formed. The second connection portions 32 are formed at the peripheral sides of the MEMS elements formed on the second substrate 24. The second connection portion 32 is formed as a protruding portion protruding from one primary surface of the second substrate 24, and a concave part having a tapered cross-sectional shape, the opening of which being decreased from a front end side of the protruding portion toward the second substrate 24, is provided in the protruding portion.

In addition, on the second substrate 24, for example, the chip-shaped first substrates 22, such as IC chips, are overlapped. The first substrates 22 are overlapped at positions corresponding to MEMS element forming portions of the second substrate 24. In this case, at a position corresponding to the second connection portion 32, the first connection portion 30 is formed on one primary surface of each first substrate 22. The first connection portion 30 is formed as a convex portion having a tapered cross-sectional shape, the width of which being increased from a front end side toward the first substrate 22. In this embodiment, as described in the manufacturing method shown in Fig. 3, a material for the first connection portion 30 and that for the second connection portion 32 are selected so that the first metal including at least one metal selected from Ga, In, and Sn and the second metal including at least one selected from Au, Cu, and Ni are brought into contact with each other.

The first substrates 22 are overlapped with the MEMS element forming portions of the second substrate 24, and as shown in Fig. 8(A), the first connection portions 30 are engaged in the concave parts of the second connection portions 32, so that temporary bonding is performed. As described above, in the state in which the first substrates 22 are overlapped on the second substrate 24, the first substrates 22 and the second substrate 24 are all heated. Accordingly, as shown in Fig. 8(B), at the contact portion between the first connection portion 30 and the second connection portion 32, the bond portion 34 is formed which is composed of an alloy of the first metal and the second metal. Since this bond portion 34 is formed, the first connection portion 30 and the second connection portion 32 are finally bonded to each other. Since the first connection portions 30 and the second connection portions 32 are finally bonded to each other, the first substrates 22 and the second substrate 24 are tightly fixed to each other. In this embodiment, when the first connection portions 30 are connected to IC circuits used as the first substrates 22, and the second connection portions 32 are connected to the MEMS elements formed on the second substrate 24, the ICs and the MEMS elements are electrically connected to each other. In addition, by further applying pressure or ultrasonic waves to the temporarily-bonded contact portion between the first connection portion 30 and the second connection portion 32, clean surfaces may be exposed at the contact portion between the first connection portion 30 and the second connection portion 32 and may be closely brought into contact with each other so as to perform the final bonding.

Furthermore, as shown in Fig. 8(C), between adjacent MEMS elements, the second substrate 24 is cut off between adjacent second connection portions 32, so that the electronic components 20 as an MEMS module are formed. The cutting of the second substrate 24 may be performed by a method, such as blade dicing, laser dicing, scribing, or cleavage.

In the manufacturing method as described above, many chips are mounted on the wafer and are simultaneously bonded, improvement in TACT and reduction in cost can be realized. For example, when 1,000 chip-shaped first substrates 22 and 1,000 chip-shaped second substrates 24 are prepared and are respectively bonded to each other, approximately 1,000 hours are required; however, by the bonding method shown in Fig. 8, the process can be completed within 2 hours. In addition, since the size of the element formed on the second substrate 24 can be minimized, the number of elements formed within the second substrate 24 can be increased, and hence cost can be reduced.

Furthermore, when the elements formed on the second substrate 24 in the form of a wafer are tested, and the first substrates 22, such as IC chips, are then mounted only on positions of non-defective elements, the yield after assembly can be improved. Since the bond portion is formed of the convex portion and the concave part, for example, when the first substrates 22 are mounted, the second substrate 24 is handled, and bonding is performed therebetween, positional displacement generated by vibration can be suppressed, and hence a strong bond against a shear force can be obtained.

In the manufacturing method shown in Fig. 8, the example in which IC chips are used as the first substrates 22 and a wafer provided with MEMS elements is used as the second substrate 24 is described by way of example; however, this method may not be limited to the combination described above and may be applied to combination of devices having different element sizes, such as an infrared sensor, a magnetic sensor, a BAW sensor, a SAW sensor, and a memory. In addition, also in the case in which connection is performed by providing interposers between elements formed on the first substrate 22 and elements formed on the second substrate 24, this manufacturing method may be used.

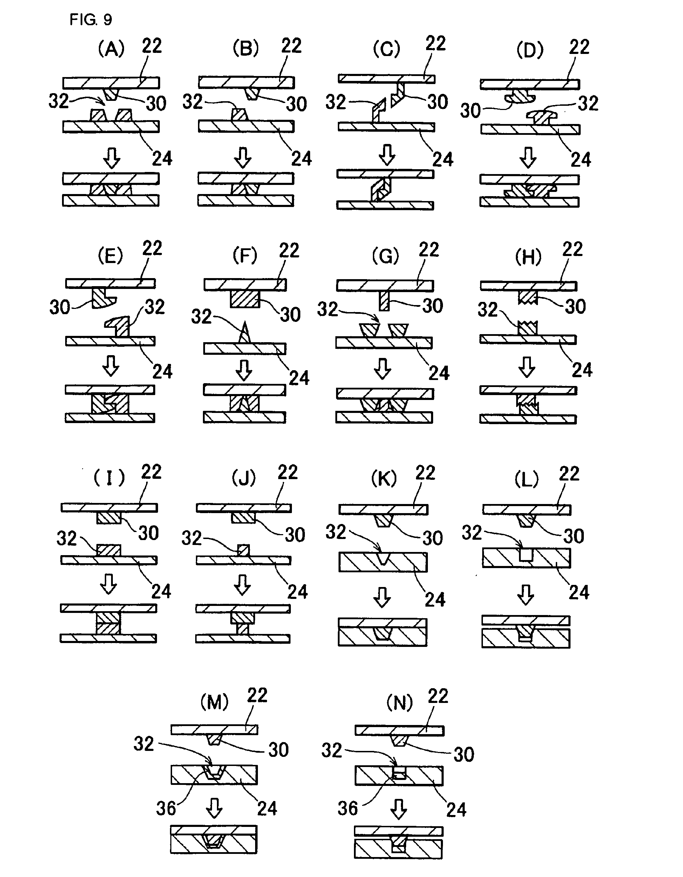

As the shape of the first connection portion 30 and that of the second connection portion 32, as shown in Figs. 9(A) to 9(N), various shapes may be conceived. Fig. 9(A) shows combination between the first connection portion 30 and the second connection portion 32 shown in Fig. 3. In addition, in Fig. 9(B), the first connection portion 30 and the second connection portion 32 are both formed to have convex shapes protruding from one primary surface of the first substrate 22 and that of the second substrate 24, respectively. However, the first connection portion 30 and the second connection portion 32 are formed at positions displaced from each other so that a side surface of the first connection portion 30 and that of the second connection portion 32 are brought into contact with each other when the first substrate 22 and the second substrate 24 are overlapped with each other. In the case of the electronic component 20 shown in Fig. 1, for example, since the circular first connection portion 30 is formed inside the circular second connection portion 32, the whole first connection portion 30 is fitted inside the second connection portion 32, so that temporary bonding is performed.

In addition, as shown in Figs. 9(C) to 9(E), the first connection portion 30 and the second connection portion 32 may be formed to have a hook shape so as to catch each other when the first substrate 22 and the second substrate 24 are overlapped with each other.

Furthermore, as shown in Fig. 9(F), the first connection portion 30 may be formed to protrude from one primary surface of the first substrate 22 and the second connection portion 32 may be formed to have a convex shape having a pointed front end. In this case, when the first substrate 22 and the second substrate 24 are overlapped with each other, the second connection portion 32 gets into the first connection portion 30, so that temporary bonding is performed.

In addition, as shown in Fig. 9(G), the first connection portion 30 may be formed to have a thin cross-sectional shape, and as the second connection portion 32, a protruding portion may be formed in which a tapered concave part is provided, the opening of which being increased from a front end side toward the second substrate 24. In this case, when the first substrate 22 and the second substrate 24 are overlapped with each other, the first connection portion 30 gets into the concave part of the second connection portion 32, and a front end portion of the first connection portion 30 is crushed by the second substrate 24, so that temporary bonding is performed.

In addition, as shown in Fig. 9(H), the first connection portion 30 and the second connection portion 32 may both be formed to have convex shapes so as to butt each other, and their front end portions may be formed to have irregularities. When the first substrate 22 and the second substrate 24 are overlapped with each other, the first connection portion 30 and the second connection portion 32 butt each other, and temporary bonding may be performed such that the irregularities of their front end portions are fitted into each other.

Furthermore, as shown in Figs. 9(I) and (J), on primary surfaces of the first substrate 22 and the second substrate 24, the first connection portion 30 and the second connection portion 32 are each formed to have a convex shape having a flat front end portion, and their front end portions of the connection portions 30 and 32 may be pushed to each other to perform temporary bonding. Fig. 9(I) shows the case in which the first connection portion 30 and the second connection portion 32 are formed so that the widths thereof are approximately equivalent to each other, and Fig. 9(J) shows the case in which the first connection portion 30 and the second connection portion 32 are formed so that the widths thereof are different from each other.

In addition, as shown in Figs. 9(K) and (L), a tapered convex portion may be formed on one primary surface of the first substrate 22 as the first connection portion 30, and a concave portion may be formed in one primary surface of the second substrate 24 as the second connection portion 32. In Fig. 9(K), the inside of the concave portion in the second substrate 24 is formed to have a narrow tapered shape as compared to that of the first connection portion 30, and when the first connection portion 30 is fitted into the second connection portion 32, the side surface of the first connection portion 30 is crushed, so that temporary bonding is performed. In addition, in Fig. 9(L), a concave portion having a uniform width as a whole is formed in the second substrate 24 as the second connection portion 32, and when the first connection portion 30 having a tapered shape is fitted into the second connection portion 32, the side surface of the first connection portion 30 is crushed, so that temporary bonding is performed.

Fig. 9(M) shows combination between the first connection portion 30 and the second connection portion 32 shown in Fig. 5 or 6. In addition, Fig. 9(N) shows the case in which on the bottom surface of the concave portion shown in Fig. 9(L), the buried portion 36 made of the first metal or the second metal is formed.

As described above, for the combination of the first connection portion 30 and the second connection portion 32, various shapes may be conceived. In particular, when the side surface of the first connection portion 30 and the side surface of the second connection portion 32 are brought into contact with each other, or when the first connection portion 30 formed to have a convex shape is fitted into the second connection portion 32 formed in the second substrate 24 to have a concave shape, the bond portion 34 formed by the above combination has strong resistance against a stress which may cause positional displacement in parallel between the first substrate 22 and the second substrate 24 and is not likely to be disengaged by the stress as described above.

In addition, in the case in which the second connection portion 32 is formed to have a concave shape, when a resin or the like is disposed on the bottom surface thereof, the bonding force of temporary bonding can be increased by the resin when the first connection portion 30 gets in the concave portion. In addition, the shape of the first connection portion 30 and that of the second connection portion 32 may be opposite to those of the examples shown in Fig. 9. That is, in Fig. 9, the shape shown as the first connection portion 30 may be used as the shape of the second connection portion 32, and the shape shown as the second connection portion 32 may be used as the shape of the first connection portion 30.

As has thus been described, according to the present invention, without generating bending and breakage of the first substrate 22 and the second substrate 24, many electronic components 20 can be efficiently formed. In addition, a large bonding force can be obtained between the first substrate 22 and the second substrate 24, and electrical connection with the element portion and sealing thereof can be reliably performed. In particular, when the first connection portion 30 and the second connection portion 32 are formed so as to surround the element portion, and sealing is performed by the bond portion 34, intrusion of moisture and dust form outside are prevented, and the electronic component 20 can be prevented from being broken.

## Claims

1. An electronic component comprising:
a first substrate and a second substrate;
a first connection portion formed on one primary surface of the first substrate;
a second connection portion formed on one primary surface of the second substrate;
a bond portion formed at a boundary at which the first connection portion and the second connection portion are in contact with each other; and
an element formed on at least one of the first substrate and the second substrate,
wherein the bond portion is formed at a contact portion between a first metal including at least one selected from Ga, In, and Sn and a second metal including at least one selected from Ni, Au, and Cu.

2. The electronic component according to Claim 1,
wherein the bond portion includes an alloy of the first metal and the second metal.

3. The electronic component according to Claim 1,
wherein the bond portion includes a close-contact surface at which the first metal and the second metal are in close contact with each other.

4. The electronic component according to one of Claims 1 to 3,
wherein the first connection portion and the second connection portion are formed by laminating a plurality of materials selected from the first metal and the second metal.

5. The electronic component according to one of Claims 1 to 4,
wherein the first connection portion is a convex portion projecting from one primary surface of the first substrate, the second connection portion is a concave part formed in a projecting portion which is formed so as to project from one primary surface of the second substrate, and the first connection portion and the second connection portion are engaged with each other, so that the bond portion is formed.

6. The electronic component according to one of Claims 1 to 4,
wherein the first connection portion is a convex portion projecting from one primary surface of the first substrate, the second connection portion is a convex portion projecting from one primary surface of the second substrate, and a side surface of the first connection portion and a side surface of the second connection portion are in contact with each other, so that the bond portion is formed at the boundary therebetween.

7. The electronic component according to one of Claims 1 to 4,
wherein the first connection portion is a convex portion projecting from one primary surface of the first substrate, the second connection portion is a concave portion formed in one primary surface of the second substrate, and the first connection portion and the second connection portion are engaged with each other, so that the bond portion is formed.

8. The electronic component according to one of Claims 1 to 7,
wherein the bond portion is formed so as to surround the element.

9. The electronic component according to one of Claims 1 to 8,
wherein the element is formed in a dip-shaped cavity portion formed in the first substrate or the second substrate.

10. The electronic component according to one of Claims 1 to 7,
wherein the element is formed on a membrane portion formed by decreasing the thickness of the first substrate or the second substrate.

11. A method for manufacturing electronic components, comprising the steps of:
preparing a first substrate and a second substrate, at least one of which is provided with elements formed on one primary surface thereof;
forming first connection portions on one primary surface of the first substrate:
forming second connection portions on one primary surface of the second substrate at positions corresponding to the first connection portions when the first substrate and the second substrate are overlapped with each other;
bringing the first connection portions and the second connection portions into contact with each other to perform preliminary bonding therebetween;
cutting the first substrate or the second substrate into chip shapes having a predetermined size;
performing final bonding between the first connection portions and the second connection portions; and
cutting the other one of the first substrate and the second substrate into chip shapes having a predetermined size.

12. A method for manufacturing electronic components, comprising the steps of:
preparing chip-shaped first substrates which are provided with elements formed on primary surfaces thereof and a plate-shaped second substrate;
forming first connection portions on primary surfaces of the first substrates:
forming second connection portions on one primary surface of the second substrate at positions corresponding to the first connection portions when the first substrates and the second substrate are overlapped with each other;
bringing the first connection portions and the second connection portions into contact with each other to perform preliminary bonding therebetween;
performing final bonding between the first connection portions and the second connection portions; and
cutting the second substrate into chip shapes.

13. The method for manufacturing electronic components, according to Claim 11 or 12,
wherein contact portions between the first connection portions and the second connection portions are each formed by bringing a first metal including at least one selected from Ga, In, and Sn into contact with a second metal.

14. The method for manufacturing electronic components, according to Claim 13,
wherein the second metal includes at least one selected from Au, Cu, and Ni.

15. The method for manufacturing electronic components, according to Claim 13 or 14,
wherein the first connection portions and the second connection portions are each formed by laminating a plurality of materials selected from the first metal and the second metal.

16. The method for manufacturing electronic components, according to one of Claims 11 to 15,
wherein the first connection portions are each formed as a convex portion projecting from one primary surface of the first substrate, and the second connection portions are each formed as a concave portion formed in one primary surface of the second substrate.

17. The method for manufacturing electronic components, according to one of Claims 11 to 16,
wherein final bonding between the first connection portions and the second connection portions is performed by heat application, pressure application, ultrasonic application, laser irradiation, or combination therebetween on the first connection portions and the second connection portions.

18. The method for manufacturing electronic components, according to one of Claims 11 to 17,
wherein the first connection portions and the second connection portions are formed so as to surround the elements.

19. The method for manufacturing electronic components, according to one of Claims 11 to 18,
wherein as the first substrate and the second substrate, substrates having a difference in coefficient of linear expansion of 12 ppm/°C or less therebetween are used.
